# DEMANDE DE BREVET EUROPEEN

(11) **EP 1 677 342 A1**
(43) Date de publication de la demande: **05.07.2006**
(21) Numéro de dépôt: 05301024.5
(22) Date de dépôt: 07.12.2005
(51) Int. Cl.: H01L 21/306

(54) **Procédé de nettoyage d'un semiconducteur**

(30) Priorité: 31.12.2004 FR 0453283
(71) Demandeur: Altis Semiconductor, 91105 Corbeil Essonnes Cedex (FR)
(72) Inventeur: Baltzinger, Jean-Luc, 91210, Draveil (FR); Asselin, Elisabeth, 77310, Pringy (FR); Renaud, Olivier, 91250, Saint Germain-Les-Corbeil (FR)
(74) Mandataire: Lenne, Laurence

(57) **Abrégé**

Procédé d'élimination de particules contaminantes du substrat d'un semiconducteur, comprenant une étape de dépôt d'un film mince en un matériau diélectrique sur le substrat. Le procédé est caractérisé en ce que l'étape de dépôt est immédiatement suivie par une étape d'attaque chimique pour retirer le film mince déposé.

## Description

La présente invention se rapporte au domaine des opérations de nettoyage lors de la fabrication des semiconducteurs.

Le procédé de fabrication des semiconducteurs fait classiquement intervenir des étapes de masquage : une couche de résine photosensible est déposée. Le semiconducteur est ensuite placé sous un masque, puis irradié. D'autres opérations intermédiaires, par exemple l'élimination de la résine irradiée, la gravure des zones non protégées par la résine restante, peuvent intervenir avant le retrait de la résine restante.

A un stade relativement peu avancé du procédé de fabrication, des tranchées, (Shallow Trench Isolation en anglais, ou STI) permettent de séparer les emplacements des futurs transistors les uns des autres. Comme décrit dans le brevet Américain 6,391,739, un matériau diélectrique peut être appliqué en quantité relativement large afin de boucher ces tranchées. Une partie du matériau diélectrique appliqué est ensuite retiré lors d'une opération de polissage, c'est à dire une érosion mécanico-chimique permettant d'obtenir une surface sensiblement plane. Le polissage peut être réalisé en utilisant un matériau abrasif mélangé à un additif chimique.

Lors de la fabrication des semiconducteurs, des impuretés, par exemple des particules, peuvent se déposer sur la surface du semiconducteur et ainsi contaminer le semiconducteur.

Les méthodes traditionnelles de nettoyage des particules contaminantes, par exemple le nettoyage par jets, ou bien une oxydation de surface suivie d'une attaque chimique, présentent une efficacité relativement faible.

La demande de brevet américaine US2004/0134515 décrit un procédé de nettoyage d'un semiconducteur. Le procédé comprend une étape de dépôt d'un film organique et une étape de retrait mécanique impliquant un fluide supercritique. Ce procédé est toutefois relativement complexe à mettre en oeuvre.

La présente invention permet un nettoyage des particules contaminantes relativement simple et relativement efficace.

La présente invention a pour objet un procédé d'élimination de particules contaminantes du substrat d'un semiconducteur, comprenant une étape de dépôt d'un film mince en un matériau diélectrique sur le substrat. Selon l'invention, cette étape de dépôt est immédiatement suivie par une étape d'attaque chimique pour retirer le film mince déposé.

Le film mince déposé a de préférence une constante élastique différente de la constante élastique du substrat du semiconducteur sur lequel le film est déposé, de telle sorte que les éventuelles particules contaminantes sont relativement désolidarisées du substrat du fait de l'étape de dépôt. Aussi, lorsque, immédiatement après le dépôt, c'est à dire sans étape intermédiaire particulière, le film mince est attaqué chimiquement, les éventuelles particules contaminantes sont détachées du substrat relativement facilement. L'étape d'attaque chimique permet de retirer le film mince déposé et facilite l'élimination des particules contaminantes.

L'étape de dépôt du film mince comprend avantageusement une étape de dépôt chimique en phase vapeur à basse pression.

Le dépôt du film mince peut également être réalisé suivant un autre procédé en phase vapeur, par exemple un procédé plasma ou encore un procédé de dépôt par pulvérisation ionique, ou plus généralement suivant n'importe quel procédé permettant de déposer un film mince sur un substrat. Par exemple le film mince peut être formé par pulvérisation et séchage d'une solution sur le substrat.

Le film mince déposé a typiquement une épaisseur d'environ 12 nanomètres. Une telle épaisseur de film mince permet de faciliter l'élimination de particules contaminantes ayant un diamètre de l'ordre du dixième de nanomètre, du nanomètre, de la dizaine de nanomètre, voire du millimètre. Bien entendu, cette caractéristique n'est pas limitative : le film mince déposé peut avoir une épaisseur moindre, par exemple de l'ordre du nanomètre, ou bien supérieure, par exemple de l'ordre du millimètre.

Le matériau diélectrique du film mince peut comprendre du nitrure de silicium. L'emploi de nitrure de silicium est particulièrement avantageux lorsque le substrat comprend du silicium et/ou de l'oxyde de silicium.

Dans ce cas, l'attaque chimique peut comprendre une étape de passage dans un bain d'acide phosphorique. L'acide phosphorique permet en effet d'attaquer le nitrure de silicium et donc de retirer la couche mince déposée.

Alternativement, le matériau diélectrique du film mince peut comprendre de l'oxyde de silicium. L'emploi d'oxyde de silicium est particulièrement avantageux lorsque le substrat comprend du silicium et/ou du nitrure de silicium.

Dans ce cas, l'attaque chimique peut comprendre une étape de passage dans un bain d'acide fluorhydrique. L'acide fluorhydrique permet en effet d'attaquer l'oxyde de silicium et donc de retirer la couche mince déposée.

L'attaque chimique peut également comprendre une étape de passage par un autre bain, et plus généralement le retrait du film mince déposé peut être réalisé de n'importe quelle manière faisant intervenir une attaque chimique, comme par exemple une gravure sèche par procédé plasma.

De plus, la présente invention n'est bien entendu pas limitée par la composition du matériau diélectrique du film mince déposé, ni par la composition du substrat.

L'invention est décrite ci-après plus en détail à l'aide de figures ne représentant qu'un mode de réalisation préféré de l'invention.

La figure 1 est une vue schématique et en coupe d'un exemple de semiconducteur contaminé par une particule.

La figure 2 est une vue schématique et en coupe du même semiconducteur après une étape de dépôt selon un mode de réalisation de la présente invention.

La figure 3 est une vue schématique et en coupe du même semiconducteur après un procédé selon un mode de réalisation de la présente invention.

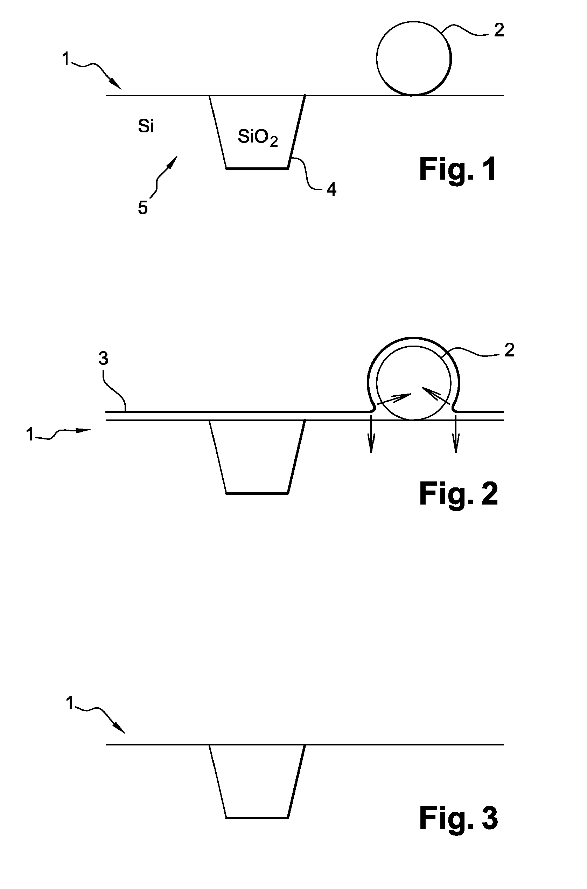

On notera que des éléments ou parties identiques ou similaires ont été désignés par les mêmes signes de référence sur les figures 1, 2 et 3.

L'exemple de semiconducteur représenté comprend un substrat 1 comprenant une zone d'oxyde de silicium 4 et une zone de silicium 5. Une particule contaminante 2 est en contact avec le substrat 1, de sorte que si des couches supplémentaires sont déposées, ou si par exemple des impuretés sont diffusées dans certaines zones du substrat 1, le semiconducteur n'aura pas forcément le comportement électrique attendu.

Selon le mode de réalisation préféré de la présente invention, un film mince 3 de nitrure de silicium est déposé sur le substrat. L'étape de dépôt a lieu en phase vapeur à basse pression (en anglais, Low Pressure Chemical Vapor Deposition ou LPCVD).

Le film mince 3 déposé a une constante élastique différente de la constante élastique du substrat 1 du semiconducteur, ce qui génère des contraintes en bord de film.

Ainsi, le silicium présente un module d'Young sensiblement autour de 169 Gpa, ou de 130 Gpa suivant les directions cristallines, tandis que le nitrure de silicium déposé en phase vapeur à basse pression présente un module d'Young sensiblement autour de 275 Gpa. La contrainte résiduelle d'un film de nitrure de silicium déposé en phase vapeur à basse pression sur un substrat de silicium a ainsi une valeur sensiblement de 1.2 Gpa.

Dans le cas d'un film de nitrure de silicium déposé par plasma à 700°C, la contrainte résiduelle a sensiblement une valeur autour de 0.6 Gpa. A 400°C, cette valeur passe sensiblement autour de -0.7 Gpa.

En particulier, des contraintes, représentées sur la figure 2 par des flèches, sont générées autour de la surface de contact entre la particule contaminante 2 et le substrat 1, désolidarisant ainsi la particule contaminante 2 du substrat 1.

Après refroidissement, le film mince 3 est attaqué chimiquement en passant le semiconducteur dans un bain d'acide phosphorique, permettant par là l'élimination de la particule contaminante 2 avec le film mince 3.

Cette succession d'étapes - dépôt d'un film mince puis attaque chimique pour retirer le film mince déposé - a pour finalité le nettoyage du substrat 1, c'est à dire l'élimination des particules contaminantes 2.

## Revendications

1. Procédé d'élimination de particules contaminantes du substrat d'un semiconducteur, comprenant
une étape de dépôt d'un film mince en un matériau diélectrique sur le substrat,
**caractérisé en ce que**
l'étape de dépôt est immédiatement suivie par une étape d'attaque chimique pour retirer le film mince déposé.

2. Procédé selon la revendication 1, **caractérisé en ce que** l'étape de dépôt du film mince comprend une étape de dépôt chimique en phase vapeur à basse pression.

3. Procédé selon l'une des revendications précédentes, **caractérisé en ce que** le film mince déposé a une épaisseur d'environ 12 nanomètres.

4. Procédé selon l'une des revendications précédentes, **caractérisé en ce que** le matériau diélectrique du film mince comprend du nitrure de silicium.

5. Procédé selon la revendication 4, **caractérisé en ce que** l'attaque chimique comprend une étape de passage dans un bain d'acide phosphorique.

6. Procédé selon l'une des revendications 1 à 3, **caractérisé en ce que** le matériau diélectrique du film mince comprend de l'oxyde de silicium.

7. Procédé selon la revendication 6, **caractérisé en ce que** l'attaque chimique comprend une étape de passage dans un bain d'acide fluorhydrique.
